# EUROPEAN PATENT APPLICATION

(11) **EP 4 686 089 A1**
(43) Date of publication of application: **28.01.2026**
(21) Application number: 24813888.5
(22) Date of filing: 02.04.2024
(51) Int. Cl.: H02S 40/34

(54) **PHOTOVOLTAIC MODULE**

(30) Priority: 02.06.2023 CN 202321401970 U; 13.06.2023 CN 202321509227 U
(71) Applicant: LONGi Green Energy Technology Co., Ltd, Xi'an, Shaanxi 710100 (CN)
(72) Inventor: WANG, Fei, Xi' an, Shanxi 710100 (CN); LIU, Zhengdong, Xi' an, Shanxi 710100 (CN); HOU, Yunlai, Xi' an, Shanxi 710100 (CN)
(74) Representative: Pfenning, Meinig & Partner mbB
(86) International application number: PCT/CN2024/085618
(87) International publication number: WO 2024/244682

(57) **Abstract**

The present application belongs to the technical field of photovoltaic modules, and specifically discloses a photovoltaic module. The photovoltaic module includes: a junction box, including a bonding pad; and a busbar, one end of the busbar being attached to a surface of the bonding pad and soldered to the bonding pad through at least one soldering joint, where the soldering joint penetrates through one end of the busbar, and extends into the bonding pad, the extension depth of the soldering joint in the bonding pad is x, the length of the soldering joint is y, y is greater than or equal to -5x+4.5, and the unit of both x and y is mm.

## Description

The present application claims priority to Chinese Patent Application No. 202321401970.3, filed with the China National Intellectual Property Administration on June 2, 2023 and entitled "PHOTOVOLTAIC MODULE", and Chinese Patent Application No. 202321509227.X, filed with the China National Intellectual Property Administration on June 13, 2023 and entitled "PHOTOVOLTAIC MODULE", which are incorporated herein by reference in their entirety.

### TECHNICAL FIELD

The present application relates to the technical field of photovoltaic modules, and in particular, to a photovoltaic module.

### BACKGROUND

A photovoltaic module includes a cell string group, a back sheet, a junction box, and a busbar. The back sheet is bonded to the cell string group through an adhesive film, the cell string group is fixed through the back sheet, and the junction box is connected to a side of the back sheet far away from the cell string group. The back sheet is provided with a through hole, one end of the busbar is connected to the cell string group, and the other end of the busbar passes through the through hole disposed in the back sheet, extends out of the back sheet, and penetrates into the junction box. A bonding pad is disposed in the junction box, and the other end of the busbar is soldered to the bonding pad to conduct the cell string group and the junction box, so that the current generated by the cell string group is conducted to an external circuit.

In the related art, a busbar is usually soldered to a bonding pad in a junction box in a manner of resistance soldering or electromagnetic soldering. Specifically, the busbar is soldered to the bonding pad by melting a tin block on the bonding pad and a tin layer on a surface layer of the busbar.

However, in an existing soldering manner, due to reasons such as impurities and uneven heating of the tin block in a soldering process, problems such as cold solder joints and desoldering exist between a busbar and a bonding pad, affecting the yield of a photovoltaic module.

### SUMMARY

An objective of the present application is to provide a photovoltaic module.

Specifically, the present application relates to the following aspects:
According to a first aspect, the present application discloses a photovoltaic module. The photovoltaic module includes: a junction box, including a bonding pad; and a busbar, one end of the busbar being attached to a surface of the bonding pad and soldered to the bonding pad through at least one soldering joint. The soldering joint penetrates through one end of the busbar, and extends into the bonding pad. An extension depth of the soldering joint in the bonding pad is x, a length of the soldering joint is y, satisfying y≥-5x+4.5, and the unit of both x and y is mm. Optionally, y≤-5x+5.5 is satisfied.

Optionally, X≥0.2 mm is satisfied.

Optionally, the quantity of the soldering joints is greater than or equal to 3 and less than or equal to 8.

Optionally, y≥1.5 mm is satisfied.

Optionally, a plurality of soldering joints are provided, the plurality of soldering joints are sequentially arranged at intervals along a width direction of the busbar, and a gap exists between two adjacent soldering joints; a width of the soldering joint is greater than or equal to 0.7 mm and less than or equal to 0.9 mm; and the gap is greater than or equal to 0.9 mm and less than or equal to 1.1 mm.

Optionally, an end surface of the bonding pad close to the busbar has a planar structure, and a side surface of the busbar attached to the bonding pad also has a planar structure.

Optionally, a material of the busbar is the same as a material of the bonding pad.

Optionally, the material of the busbar and the material of the bonding pad are both copper.

Optionally, the material of the busbar is different from the material of the bonding pad.

Optionally, a width of the busbar is greater than or equal to 5 mm, and a thickness of the busbar is greater than or equal to 0.2 mm.

Optionally, the soldering joint is formed by laser soldering.

Optionally, the junction box is fixed onto a back sheet of the photovoltaic module, and the busbar extends into the junction box through a through hole of the back sheet.

According to a second aspect, the present application further discloses a photovoltaic module. The photovoltaic module includes a junction box. The junction box includes a bonding pad; and a busbar, one end of the busbar being attached to a surface of the bonding pad and soldered to the bonding pad through at least one soldering joint. The soldering joint penetrates through one end of the busbar, and extends into the bonding pad. An extension depth of the soldering joint in the bonding pad is x, satisfying x≥0.2 mm. Optionally, the quantity of the soldering joints is greater than or equal to 3 and less than or equal to 8.

Optionally, the length of the soldering joint is greater than or equal to 1.5 mm.

Optionally, a plurality of soldering joints are provided, the plurality of soldering joints are sequentially arranged at intervals along a width direction of the busbar, and a gap exists between two adjacent soldering joints; a width of the soldering joint is greater than or equal to 0.7 mm and less than or equal to 0.9 mm; and the gap is greater than or equal to 0.9 mm and less than or equal to 1.1 mm.

Optionally, an end surface of the bonding pad close to the busbar has a planar structure, and a side surface of the busbar attached to the bonding pad also has a planar structure.

Optionally, a material of the busbar is the same as a material of the bonding pad.

Optionally, the material of the busbar and the material of the bonding pad are both copper.

Optionally, the material of the busbar is different from the material of the bonding pad.

Optionally, a width of the busbar is greater than or equal to 5 mm, and a thickness of the busbar is greater than or equal to 0.2 mm.

Optionally, the soldering joint is formed by laser soldering.

Optionally, the junction box is fixed onto a back sheet of the photovoltaic module, and the busbar extends into the junction box through a through hole of the back sheet.

According to a third aspect, the present application further discloses a photovoltaic module, including a junction box and a busbar. The junction box includes a bonding pad and a diode. The bonding pad and the diode are disposed in parallel along a first direction. The busbar and the bonding pad are soldered together by laser soldering, a plurality of soldering joints are formed by the laser soldering, and the plurality of soldering joints penetrate through the busbar and extend into the bonding pad. An edge of the soldering joint closest to the diode along the first direction is a first edge, and an edge of the diode closest to the soldering joint along the first direction is a second edge. A safe distance is reserved between the first edge and the second edge, the safe distance is a linear distance between the first edge and the second edge in the first direction, and the safe distance is greater than or equal to 3 mm.

Optionally, the bonding pad and/or the busbar has a sheet structure and has a flat soldering surface.

Optionally, the plurality of soldering joints form a soldering pattern, and a minimum distance between an edge of the soldering pattern and an edge of the bonding pad is greater than or equal to 1.5 mm.

Optionally, the junction box further includes a box body, the box body includes a box wall surrounding the bonding pad, and a minimum distance between the soldering pattern and the box wall is greater than or equal to 2.5 mm.

Optionally, an end of the bonding pad far away from the diode is provided with a locating hole, a bottom of the box body is provided with a locating column, and the locating column is inserted through the locating hole.

Optionally, a minimum distance between the soldering pattern and the locating column is greater than or equal to 1 mm.

Optionally, a position of the bonding pad opposite to the diode is provided with a limiting protrusion; the bonding pad is soldered to a lead of the diode; and the limiting protrusion extends along the first direction, the lead is disposed between the limiting protrusion and the bottom of the box body, and the limiting protrusion is configured to limit the lead to ensure that the lead is laid out along the first direction.

Optionally, the quantity of the bonding pads is two; the two bonding pads are symmetrically disposed on two sides of the diode along the first direction; and the two bonding pads are respectively soldered to the two leads of the diode.

Optionally, the quantity of the soldering joints is greater than or equal to four.

Optionally, a length of the soldering joints is greater than or equal to 3 mm, and a distance between two adjacent soldering joints is greater than or equal to 0.7 mm.

Optionally, a width of the busbar is greater than or equal to 5 mm, and a thickness of the busbar is greater than or equal to 0.2 mm.

The present application discloses a photovoltaic module. The photovoltaic module includes: a junction box, including a bonding pad; and a busbar, one end of the busbar being attached to a surface of the bonding pad and soldered to the bonding pad through at least one soldering joint. The soldering joint penetrates through one end of the busbar, and extends into the bonding pad. An extension depth of the soldering joint in the bonding pad is x, the length of the soldering joint is y, satisfying y≥-5x+4.5, and the unit of both x and y is mm. In the present application, one end of the busbar is attached to the surface of the bonding pad, and is soldered to the bonding pad through at least one soldering joint. In addition, the length y of the soldering joint is set to be inversely proportional to the extension depth x of the soldering joint in the bonding pad, so as to ensure the soldering strength between the busbar and the bonding pad, avoid problems such as desoldering and cold solder joints between the busbar and the bonding pad, and improve the process yield of the photovoltaic module.

The foregoing descriptions are merely an overview of the technical solutions of the present application. To understand the technical means of the present application more clearly, implementation can be performed according to the content of the specification. Moreover, to make the foregoing and other objectives, features, and advantages of the present application more comprehensible, specific embodiments of the present application are particularly described below.

### BRIEF DESCRIPTION OF THE DRAWINGS

To describe technical solutions in embodiments of the present application or related technologies more clearly, the following briefly introduces accompanying drawings required for describing the embodiments or related technologies. Apparently, the accompanying drawings in the following descriptions show some of the embodiments of the present application. Those of ordinary skill in the art can also obtain other accompanying drawings according to these accompanying drawings without creative work.
FIG. 1 is a top view of a soldering joint in the present application;
FIG. 2 is another top view of the soldering joint in the present application;
FIG. 3 is a cross-sectional view of the soldering joint in the present application;
FIG. 4 is a view showing a relationship between the length y of the soldering joint and an extension depth x of the soldering joint in the bonding pad in the present application;
FIG. 5 is a schematic structural view of a photovoltaic module in the present application;
FIG. 6 is a schematic structural view of another photovoltaic module in the present application;
FIG. 7 is a schematic structural view of a diode in the present application;
FIG. 8 is a schematic structural view of still another photovoltaic module in the present application;
FIG. 9A is a schematic structural view of a bonding pad in the present application; and
FIG. 9B is a schematic structural view of another bonding pad in the present application.

### Reference numerals:

10: bonding pad; 11: locating hole; 12: limiting protrusion; 20: busbar; 30: soldering joint; 40: diode; 41: lead; 50: leading-out wire.

### DETAILED DESCRIPTION

To make the objectives, technical solutions, and advantages of the embodiments of the present application clearer, the following clearly and completely describes the technical solutions in the embodiments of the present application with reference to the accompanying drawings in the embodiments of the present application. Apparently, the described embodiments are some rather than all of the embodiments of the present application. All other embodiments obtained by those of ordinary skill in the art based on the embodiments in the present application without making creative work shall fall within the protection scope of the present application.

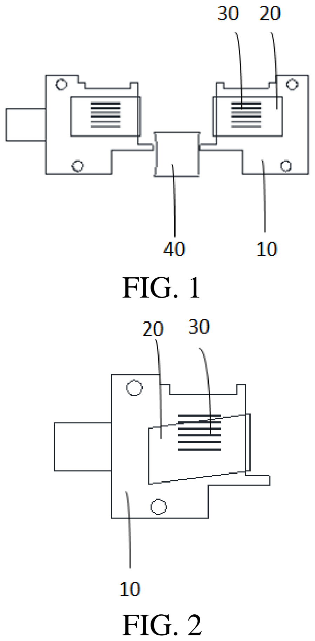

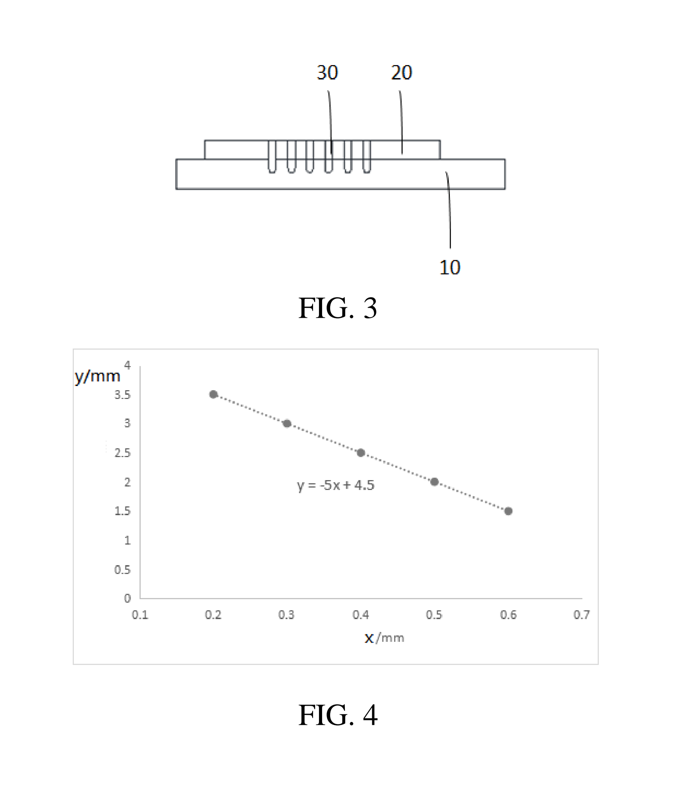

Referring to FIG. 1, it is a top view of the soldering joint in the present application. Referring to FIG. 2, it is another top view of the soldering joint in the present application. Referring to FIG. 3, it is a cross-sectional view of the soldering joint in the present application. Referring to FIG. 4, it shows a relationship between a length y of the soldering joint and an extension depth x of the soldering joint in the bonding pad in the present application.

As shown in FIG. 1 to FIG. 4, an embodiment of the present application provides a photovoltaic module. The photovoltaic module includes: a junction box, including a bonding pad 10; and a busbar 20, one end of the busbar 20 being attached to a surface of the bonding pad 10 and soldered to the bonding pad 10 through at least one soldering joint 30. The soldering joint 30 penetrates through one end of the busbar 20, and extends into the bonding pad 10, the extension depth of the soldering joint 30 in the bonding pad 10 is x, the length of the soldering joint 30 is y, satisfying y≥-5x+4.5, and the unit of both x and y is mm.

In this embodiment of the present application, x may be less than 0.9 mm. Optionally, x is less than or equal to 0.7 mm. In this embodiment of the present application, the extension depth x of the soldering joint 30 in the bonding pad 10 is set to be less than 0.9 mm. Optionally, x is less than or equal to 0.7 mm. By means of the foregoing setting, unnecessary excessive soldering caused by an excessively large x can be avoided.

Generally, the photovoltaic module can generate a current under the illumination of sunlight, that is, convert solar energy into electric energy. A plurality of solar cells are soldered together through a soldering band to form a cell string. A plurality of cell strings are connected in series or in parallel to form a cell string group. A plurality of cell string groups are connected in series or in parallel through the busbar 20 to form the photovoltaic module. The photovoltaic module can aggregate the current generated by the plurality of solar cells to form a relatively large current.

The photovoltaic module in this embodiment of the present application includes a junction box. The junction box includes a box body and a bonding pad 10 and a diode 40 that are disposed in the box body. The box body is connected to one side of the photovoltaic module. Generally, there are two bonding pads 10, and the two bonding pads 10 are both soldered to the diode 40.

The photovoltaic module in this embodiment of the present application further includes a busbar 20. One end of the busbar 20 is soldered between two adjacent cell string groups, and the other end of the busbar 20 extends into the box body and is attached to a surface of the bonding pad 10.

The end of the busbar 20 attached to the surface of the bonding pad 10 is soldered to the bonding pad 10 through at least one soldering joint 30. Optionally, the end of the busbar 20 attached to the surface of the bonding pad 10 is soldered to the bonding pad 10 in a manner of laser scanning soldering. Of course, the end of the busbar 20 attached to the surface of the bonding pad 10 may also be soldered to the bonding pad 10 in another soldering manner. This is not excessively limited in this embodiment of the present application.

When the busbar 20 and the bonding pad 10 are soldered together in a manner of laser scanning soldering, the soldering strength between the busbar 20 and the bonding pad 10 is higher, and the reliability is better. In this way, the probability of occurrence of cold solder joints and desoldering problems between the busbar 20 and the bonding pad 10 can be reduced.

It should be noted that when the soldering joints 30 are formed in a manner of laser scanning soldering, the soldering joints 30 may be continuous straight line segments, or may be dashed line segments formed by a plurality of intermittent soldering points. The soldering joint 30 may be implemented by properly adjusting a moving speed and a pulse interval of a pulse laser. Details are not described herein again.

The soldering joint 30 in this embodiment of the present application penetrates through one end of the busbar 20, and extends into the bonding pad 10. In addition, the extension depth of the soldering joint 30 in the bonding pad 10 is x, and the length of the soldering joint 30 is y, where y≥-5x+4.5 is satisfied. The unit of both the extension depth x of the soldering joint 30 in the bonding pad 10 and the length y of the soldering joint 30 is mm.

Specifically, as shown in FIG. 4, when the extension depth x of the soldering joint 30 in the bonding pad 10 is x=0.2 mm, the length y of the soldering joint 30 is greater than or equal to 3.5 mm. When the extension depth x of the soldering joint 30 in the bonding pad 10 is x=0.3 mm, the length y of the soldering joint 30 is greater than or equal to 3 mm. When the extension depth x of the soldering joint 30 in the bonding pad 10 is x=0.4 mm, the length y of the soldering joint 30 is greater than or equal to 2.5 mm. When the extension depth x of the soldering joint 30 in the bonding pad 10 is x=0.5 mm, the length y of the soldering joint 30 is greater than or equal to 2 mm. When the extension depth x of the soldering joint 30 in the bonding pad 10 is x=0.6 mm, the length y of the soldering joint 30 is greater than or equal to 1.5 mm.

In this embodiment of the present application, the length y of the soldering joint 30 is set to be inversely proportional to the extension depth x of the soldering joint 30 in the bonding pad 10, so as to ensure the soldering strength between the busbar 20 and the bonding pad 10, avoid problems such as desoldering and cold solder joints between the busbar 20 and the bonding pad 10, and improve the process yield of the photovoltaic module.

The present application provides a photovoltaic module. The photovoltaic module includes: a junction box, including a bonding pad 10; and a busbar 20, one end of the busbar 20 being attached to a surface of the bonding pad 10 and soldered to the bonding pad 10 through at least one soldering joint 30, where the soldering joint 30 penetrates through one end of the busbar 20, and extends into the bonding pad 10, the extension depth of the soldering joint 30 in the bonding pad 10 is x, a length of the soldering joint 30 is y, satisfying y≥-5x+4.5, and the unit of both x and y is mm. In this embodiment of the present application, one end of the busbar 20 is attached to the surface of the bonding pad 10, and is soldered to the bonding pad 10 through at least one soldering joint 30. The length y of the soldering joint 30 is set to be inversely proportional to the extension depth x of the soldering joint 30 in the bonding pad 10, so as to ensure the soldering strength between the busbar 20 and the bonding pad 10, avoid problems such as desoldering and cold solder joints between the busbar 20 and the bonding pad 10, and improve the process yield of the photovoltaic module.

In an embodiment, y≤-5x+5.5 is satisfied.

In this embodiment of the present application, the length y of the soldering joint 30 is set to be less than or equal to -5x+5.5. When the extension depth x of the soldering joint 30 in the bonding pad 10 is relatively large, for example, when the extension depth x of the soldering joint 30 in the bonding pad 10 is x=0.7 mm, the length y of the soldering joint 30 may be less than or equal to 2 mm. For another example, when the extension depth x of the soldering joint 30 in the bonding pad 10 is x=0.6 mm, the length y of the soldering joint 30 may be less than or equal to 2.5 mm. Therefore, the energy consumption is reduced while the soldering strength between the busbar 20 and the bonding pad 10 is ensured, and unnecessary excessive soldering is avoided.

Specifically, when the extension depth x of the soldering joint 30 in the bonding pad 10 is x=0.2 mm, the length y of the soldering joint 30 is less than or equal to 4.5 mm. When the extension depth x of the soldering joint 30 in the bonding pad 10 is x=0.3 mm, the length y of the soldering joint 30 is less than or equal to 4 mm. When the extension depth x of the soldering joint 30 in the bonding pad 10 is x=0.4 mm, the length y of the soldering joint 30 is less than or equal to 3.5 mm. When the extension depth x of the soldering joint 30 in the bonding pad 10 is x=0.5 mm, the length y of the soldering joint 30 is less than or equal to 3 mm.

In an embodiment, x≥0.2 mm is satisfied.

In this embodiment of the present application, the extension depth x of the soldering joint 30 in the bonding pad 10 is set to be greater than or equal to 0.2 mm. It can be understood that as long as the extension depth x of the soldering joint 30 in the bonding pad 10 is greater than or equal to 0.2 mm, the soldering strength between the busbar 20 and the bonding pad 10 can be ensured. That is, the soldering reliability between the busbar 20 and the bonding pad 10 is relatively high. In this way, problems such as desoldering and cold solder joints between the busbar 20 and the bonding pad 10 can be avoided, thereby improving the process yield of the photovoltaic module.

Specifically, the extension depth x of the soldering joint 30 in the bonding pad 10 may be set to 0.25 mm, 0.35 mm, 0.45 mm, 0.55 mm, 0.65 mm, or the like. This is not specifically limited. During actual use, a skilled person may set according to requirements.

It should be noted that in this embodiment of the present application, the extension depth x of the soldering joint 30 in the bonding pad 10 may also be set to be greater than or equal to 0.2 mm and less than or equal to 0.9 mm. Optionally, x is greater than or equal to 0.2 mm and less than or equal to 0.9 mm. Therefore, the soldering strength between the busbar 20 and the bonding pad 10 is ensured, and unnecessary waste caused by excessive soldering depth is avoided.

In an embodiment, the quantity of the soldering joints is greater than or equal to 3 and less than or equal to 8.

In this embodiment of the present application, the quantity of the soldering joints 30 is set to be greater than or equal to 3 and less than or equal to 8. Specifically, a plurality of soldering joints 30 may be disposed at intervals along a width direction of the busbar 20, and a specific quantity of the soldering joints 30 may be properly set according to a width of the busbar 20 and the spacing between the soldering joints 30. The quantity of the soldering joints 30 may be set to 3, 4, 5, 6, 7, or 8.

It should be noted that the quantity of the soldering joints 30 at least should not be less than 3. In this way, when the extension depth x of the soldering joint 30 in the bonding pad 10 and the length y of the soldering joint satisfy: y≥-5x+4.5, the soldering strength and a better electrical connection effect can be fully ensured. In addition, the quantity of the soldering joints 30 is not greater than 8, so that the efficiency of laser soldering can be considered while ensuring the soldering quality.

In this embodiment of the present application, it should be noted that the quantity of the soldering joints 30 is set to be greater than or equal to 3. As shown in FIG. 2, when the busbar 20 is attached to the surface of the bonding pad 10, due to a process error, the busbar 20 may have a deviation, resulting in an included angle between an extension direction of the soldering joint 30 and an extension direction of the busbar 20. The quantity of the soldering joints 30 is set to be greater than or equal to 3. In a case that an included angle exists between the extension direction of the soldering joint 30 and the extension direction of the busbar 20, the soldering joint 30 still penetrates through one end of the busbar 20, and extends into the bonding pad 10, thereby ensuring the soldering reliability between the busbar 20 and the bonding pad 10.

In an embodiment, y≥1.5 mm is satisfied.

In this embodiment of the present application, the length y of the soldering joint 30 is set to be greater than or equal to 1.5 mm, thereby avoiding an error caused by a process reason, resulting in a too small soldering area and affecting the soldering quality.

Specifically, the length y of the soldering joint 30 may be set to 2 mm, 2.3 mm, 2.6 mm, 2.9 mm, 3.2 mm, 3.5 mm, or the like. This is not specifically limited in this embodiment of the present application. During actual use, a skilled person may set the length y of the soldering joint 30 according to requirements, provided that the length y of the soldering joint 30 is greater than or equal to 1.5 mm.

Optionally, a plurality of soldering joints 30 are provided, the plurality of soldering joints 30 are sequentially arranged at intervals along a width direction of the busbar 20, and a gap exists between two adjacent soldering joints 30, where a width of the soldering joint 30 is greater than or equal to 0.7 mm and less than or equal to 0.9 mm; and the gap is greater than or equal to 0.9 mm and less than or equal to 1.1 mm.

In this embodiment of the present application, as shown in FIG. 1 and FIG. 2, a plurality of soldering joints 30 are provided, and the plurality of soldering joints 30 are sequentially arranged at intervals along the width direction of the busbar 20. It can be understood that a length direction of the soldering joint 30 is the same as a length direction of the busbar 20, and a gap exists between two adjacent soldering joints 30.

To further improve the soldering reliability between the busbar 20 and the bonding pad 10, in this embodiment of the present application, the width of the soldering joint 30 is set to be greater than or equal to 0.7 mm and less than or equal to 0.9 mm. Specifically, the width of the soldering joint 30 may be set to 0.7 mm, 0.75 mm, 0.8 mm, 0.85 mm, 0.9 mm, or the like.

Similarly, to improve the soldering reliability between the busbar 20 and the bonding pad 10, in this embodiment of the present application, a gap between two adjacent soldering joints 30 is set to be greater than or equal to 0.9 mm and less than or equal to 1.1 mm. Specifically, a gap between two adjacent soldering joints 30 may be set to 0.9 mm, 0.95 mm, 1 mm, 1.05 mm, 1.1 mm, or the like.

Optionally, an end surface of the bonding pad 10 close to the busbar 20 has a planar structure, and a side surface of the busbar 20 attached to the bonding pad 10 also has a planar structure.

In this embodiment of the present application, as shown in FIG. 3, the end surface of the bonding pad 10 close to the busbar 20 is set to be of a planar structure, and the side surface of the busbar 20 attached to the bonding pad 10 is also set to be of a planar structure. It can be ensured that the side surface of the busbar 20 is better attached to the end surface of the bonding pad 10 close to the busbar 20, thereby improving the soldering reliability between the busbar 20 and the bonding pad 10.

Optionally, the material of the busbar 20 is the same as the material of the bonding pad 10.

In this embodiment of the present application, the busbar 20 and the bonding pad 10 are made of a same material. For example, the busbar 20 may be made of copper, and the bonding pad 10 may also be made of copper. The busbar 20 made of copper and the bonding pad 10 made of copper are soldered together in a manner of laser scanning soldering, so that the busbar 20 and the bonding pad 10 at the soldering joint 30 are fused again and chilled to form an integral structure. The degree of fusion between the busbar 20 and the bonding pad 10 made of the same material is higher, so that the soldering reliability between the busbar 20 and the bonding pad 10 can be improved, and the probability of desoldering between the busbar 20 and the bonding pad 10 can be reduced.

It should be noted that the busbar 20 and the bonding pad 10 in this embodiment of the present application may also be made of other metal materials. This is not specifically limited in this embodiment of the present application. During actual use, a skilled person may make a selection according to requirements.

Optionally, the material of the busbar 20 is different from the material of the bonding pad 10.

Even though the busbar 20 and the bonding pad 10 in this embodiment of the present application are made of different materials. For example, the busbar 20 is made of copper and the bonding pad 10 is made of aluminum, the busbar 20 made of copper and the bonding pad 10 made of aluminum may also be soldered together in a manner of laser scanning soldering, so that the busbar 20 and the bonding pad 10 at the soldering joint 30 are fused again and chilled to form an integral structure, thereby improving the soldering reliability between the busbar 20 and the bonding pad 10.

Optionally, the width of the busbar 20 is greater than or equal to 5 mm, and the thickness of the busbar 20 is greater than or equal to 0.2 mm.

In this embodiment of the present application, the size of the bonding pad 10 is not limited. In the related art, the size of the bonding pad 10 commonly used can satisfy the use requirement in this embodiment of the present application.

In this embodiment of the present application, to enable a plurality of soldering joints 30 to be disposed on the busbar 20 at intervals along the width direction of the busbar 20, a requirement is put forward for the width of the busbar 20. The width of the busbar 20 is set to be greater than or equal to 5 mm. Specifically, the width of the busbar 20 may be set to 5 mm, 6 mm, 7 mm, 8 mm, 9 mm, 10 mm, or the like.

In addition, in this embodiment of the present application, the thickness of the busbar 20 is set to be greater than or equal to 0.2 mm, so as to avoid that the extension depth x of the soldering joint 30 in the bonding pad 10 is relatively large, causing the bonding pad 10 to burn through. Specifically, the thickness of the busbar 20 may be set to 0.2 mm, 0.3 mm, 0.4 mm, 0.5 mm, 0.6 mm, or the like.

Optionally, the soldering joint 30 is formed by laser soldering.

In this embodiment of the present application, one end of the busbar 20 is soldered to the bonding pad 10 in a manner of laser scanning soldering. Therefore, the soldering strength between the busbar 20 and the bonding pad 10 is higher, and the reliability is better. The busbar 20 and the bonding pad 10 do not need to be soldered together through metallic tin, thereby reducing the probability of occurrence of cold solder joints and desoldering problems between the busbar 20 and the bonding pad 10.

Optionally, the junction box is fixed onto a back sheet of the photovoltaic module, and the busbar 20 extends into the junction box through a through hole of the back sheet.

A back surface of the photovoltaic module is generally provided with a back sheet. Generally, the back sheet is bonded to the back surface of a cell string group through an adhesive film, so as to protect the cell string group through the back sheet and provide support for the cell string group.

The back sheet may be a glass back sheet. When the cell string group is protected through the glass back sheet, light can also penetrate through the glass back sheet to reach the surface of the cell string surface, so that the efficiency of converting solar energy into electric energy by the cell string group is not affected.

The junction box is fixedly connected to the back sheet. One end of the busbar 20 is soldered between the cell string groups, a through hole is provided in the back sheet, and the other end of the busbar 20 passes through the through hole and extends into the junction box and is attached to the surface of the bonding pad 10. Therefore, the cell string group is electrically connected to the bonding pad 10, so as to lead the current generated by the cell string group to an external circuit.

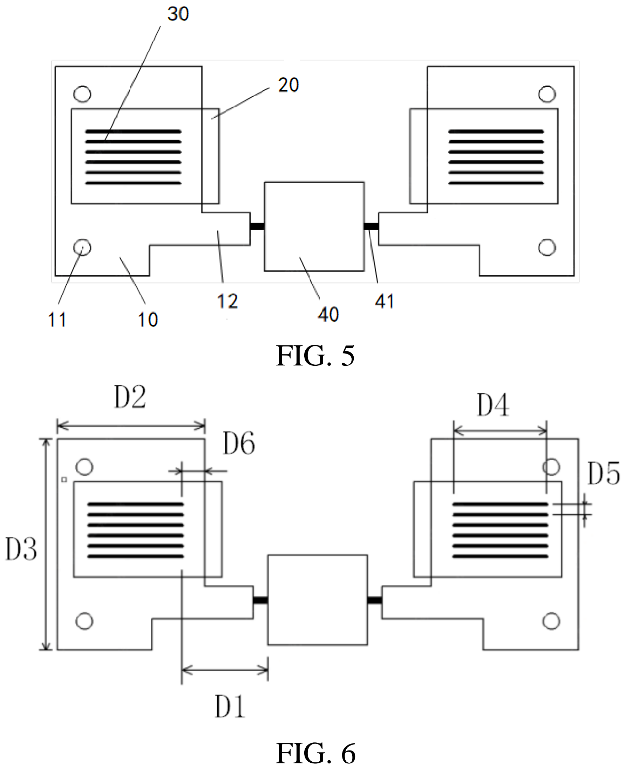

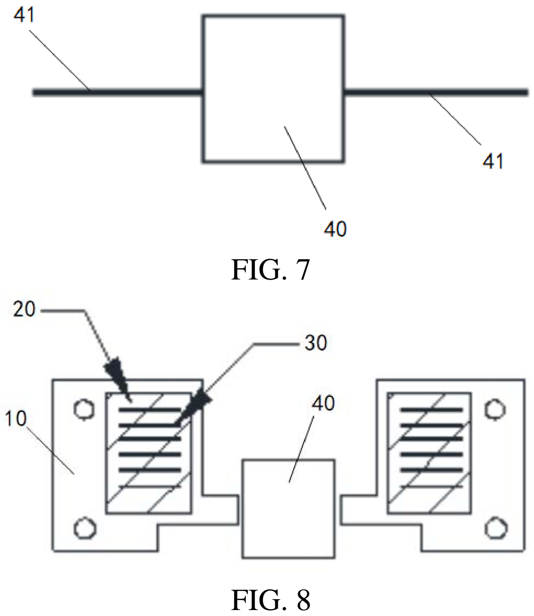

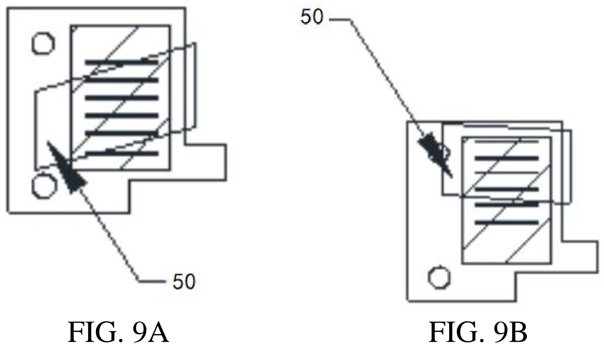

Referring to FIG. 5, it is a schematic structural view of a photovoltaic module in the present application. Referring to FIG. 6, it is a schematic structural view of another photovoltaic module in the present application. Referring to FIG. 7, it is a schematic structural view of a diode in the present application. Referring to FIG. 8, it is a schematic structural view of still another photovoltaic module in the present application. Referring to FIG. 9A, it is a schematic structural view of a bonding pad in the present application. Referring to FIG. 9B, it is a schematic structural view of another bonding pad in the present application.

As shown in FIG. 5 to FIG. 9B, an embodiment of the present application discloses a photovoltaic module, including a junction box and a busbar 20. The junction box may specifically include a bonding pad 10 and a diode 40. The bonding pad 10 and the diode 40 may be disposed in parallel along the first direction. The busbar 20 and the bonding pad 10 can be soldered together by laser soldering, and a plurality of soldering joints 30 can be formed by laser soldering. The plurality of soldering joints 30 can penetrate through the busbar 20 and extend into the bonding pad 10. An edge of the soldering joint 30 closest to the diode 40 along the first direction is a first edge, and an edge of the diode 40 closest to the soldering joint 30 along the first direction is a second edge. A safe distance is reserved between the first edge and the second edge, the safe distance is a linear distance between the first edge and the second edge in the first direction, and the safe distance is greater than or equal to 3 mm.

In this embodiment of the present application, the bonding pad 10 and the diode 40 are disposed in parallel along the first direction. The bonding pad 10 and the busbar 20 are soldered by laser soldering, and a plurality of soldering joints 30 are formed. An edge of the soldering joint 30 closest to the diode 40 along the first direction is a first edge, and an edge of the diode 40 closest to the soldering joint 30 along the first direction is a second edge. Because there is a safe distance between the first edge and the second edge and the safe distance is greater than or equal to 3 mm, a sufficient gap between the soldering joint 30 and the diode 40 can be effectively ensured. In this way, in a process of soldering the bonding pad 10 to the busbar 20, a short circuit of the diode 40 caused by soldering can be avoided, thereby improving the soldering process yield.

In this embodiment of the present application, the busbar 20 includes a copper bottom plate, and the bonding pad 10 of the junction box may be a copper bonding pad. Because the material of the bonding pad 10 is the same as the material of the copper bottom plate of the busbar 20, a laser soldering process may be used to fuse and recast a soldering portion of the copper bonding pad and the copper plate of the busbar 20. The copper plate of the busbar 20 and the soldering portion of the bonding pad 10 may be fused and recast into an integral structure, so that a plurality of soldering joints 30 may be formed between the busbar 20 and the bonding pad 10. Therefore, the soldering firmness between the busbar 20 and the bonding pad 10 is higher, and a desoldering proportion is lower.

Further, when the bonding pad 10 and the busbar 20 are soldered by laser soldering, there is no need to use a tin block, and two-phase co-fusion between tin and copper can be further avoided, thereby reducing the impact of impurities, reducing the risk of fault or splitting, and facilitating long-term stability between the bonding pad 10 and the busbar 20.

Specifically, a plurality of soldering joints 30 are formed between the bonding pad 10 and the busbar 20 by laser soldering. The plurality of soldering joints 30 are concentrated in a soldering area on the bonding pad 10. That is, the position of the soldering area can be fixed. Because instantaneous energy of laser soldering is very high, in this embodiment of the present application, the safe distance between the soldering joint 30 and the diode 40 can be controlled to prevent an offset error in a soldering process from damaging the diode 40.

Specifically, an edge of the soldering joint 30 closest to the diode 40 along the first direction is used as a first edge, an edge of the diode 40 closest to the soldering joint 30 along the first direction is used as a second edge, the first direction is a direction in which the bonding pad 10 and the diode 40 are disposed in parallel, and the safe distance between the soldering joint 30 and the diode 40 may be a linear distance between the first edge and the second edge in the first direction. As shown in FIG. 6, the safe distance D1 is greater than or equal to 3 mm, which can effectively avoid that the laser energy in a soldering process burns the diode 40.

Exemplarily, as shown in FIG. 6, the length D2 of the bonding pad 10 extending along the first direction may be 13±0.5 mm, and the length D3 of the bonding pad 10 extending along the third direction may be 15±0.5 mm. The first direction may be a width direction of the bonding pad 1, and the third direction may be a length direction of the bonding pad 1. The length of the soldering area on the bonding pad 1 along the first direction may be 7±0.5 mm, and the length of the soldering area along the third direction may be 10±0.5 mm.

Specifically, a soldering pressure head presses down the soldering area, a leading-out wire 50 of the junction box and the bonding pad 10 may be flattened, and then, the laser passes through the inside of the pressure head to implement soldering. A thickness of the outer wall of the pressure head may be 0.8±0.1 mm to ensure a linear distance between the first edge and the second edge in the first direction, that is, a safe distance between the soldering joint 30 and the diode 40. The safe distance may be controlled to be greater than or equal to 3 mm to reduce the risk of damaging the diode 40 in a soldering process.

Optionally, the safe distance is greater than or equal to 4.48 mm and is less than or equal to 6.48 mm, so that the safe distance between the soldering joint 30 and the diode 40 is sufficient, and laser soldering between the bonding pad 10 and the busbar 20 can be prevented from affecting the diode 40.

It should be noted that this embodiment of the present application is only illustrative. After the junction box is adjusted, the safe distance between the soldering joint 30 and the diode 40, that is, the linear distance between the first edge and the second edge in the first direction, may be accordingly optimized.

Optionally, the bonding pad 10 may include a bonding pad body and a soldering portion. The soldering portion may be used for laser soldering with the busbar 20. The soldering joint 30 may penetrate through the busbar 20 and extend to the soldering portion. The bonding pad body and the soldering portion may be integrally formed to further improve the structural stability of the bonding pad 10.

Specifically, in a case that the bonding pad body and the soldering portion are integrally formed, a line may be further scribed at an edge of the soldering portion, so as to facilitate the location of the soldering portion. Or, the soldering portion may also be located according to an actual requirement and a statistical result of data.

Optionally, the bonding pad body may be provided with a groove, and the soldering portion may be embedded in the groove, so as to implement the splicing of the bonding pad body and the soldering portion.

Optionally, the bonding pad 10 and/or the busbar 20 may have a sheet structure and have a flat soldering surface, so that the bonding pad 10 and/or the busbar 20 may form completely flat plate structures without depressions or inclinations, thereby facilitating the operation of soldering the bonding pad 10 and the busbar 20, and simplifying the structures of the bonding pad 10 and the busbar 20.

Optionally, a plurality of soldering joints 30 may form a soldering pattern, a minimum distance D6 between an edge of the soldering pattern and an edge of the bonding pad 10 may be greater than or equal to 1.5 mm, and a sufficient space may be reserved on the bonding pad 10. In this way, during the laser soldering of the bonding pad 10 and the busbar 20, it is convenient for a pressure head of a soldering device to press down.

Optionally, the quantity of the soldering joints 30 may be greater than or equal to 4. Because the soldering joints 30 penetrate through the busbar 20 and extend into the bonding pad 10, that is, the soldering joints 30 play a role in fixing the bonding pad 10 and the busbar 20, by ensuring that the quantity of the soldering joints 30 is greater than or equal to 4, the reliability and stability of fixed connection between the bonding pad 10 and the busbar 20 can be improved.

Optionally, the quantity of the soldering joints 30 may be 6.

Optionally, a plurality of soldering joints 30 may be disposed in parallel. As shown in FIG. 6, a length D4 of each of the soldering joints 30 may be greater than or equal to 3 mm, and a distance D5 between two adjacent soldering joints 30 may be greater than or equal to 0.7 mm, thereby improving the reliability of laser soldering between the bonding pad 10 and the busbar 20.

Optionally, a thickness of the bonding pad 10 may be greater than or equal to 0.8 mm, so that the thickness of the bonding pad 10 can be effectively ensured, and the bonding pad 10 can be prevented from being burnt through.

Optionally, the width of the busbar 20 may be greater than or equal to 5 mm, and the thickness of the busbar 20 may be greater than or equal to 0.2 mm, thereby effectively ensuring that a plurality of soldering joints 30 are formed between the bonding pad 10 and the busbar 20, so as to reliably fix the bonding pad 10 and the busbar 20.

Optionally, the junction box may further include a box body, the box body may include a box wall surrounding the bonding pad 10, and a minimum distance between the soldering pattern and the box wall may be greater than or equal to 2.5 mm, so that there is a sufficient space between the soldering pattern and the box wall, which is convenient for a soldering pressure head to press down the busbar 20.

Optionally, one end of the bonding pad 10 far away from the diode 40 may be provided with a locating hole 11, and a bottom of the box body may be provided with a locating column. The locating column may be inserted through the locating hole 11.

In this embodiment of the present application, the locating column is inserted through the locating hole 11, so as to implement the limiting connection between the bonding pad 10 and the bottom of the box body, so that the bonding pad 10 can be fixed in the box body.

Specifically, the quantity of the locating columns and the quantity of the locating holes 11 may be set in a one-to-one correspondence manner. As shown in FIG. 5 and FIG. 6, a configuration with four locating posts for illustrative purposes only is shown. The quantity of the locating columns may be set according to actual requirements, and is not specifically limited in this embodiment of the present utility model.

Optionally, a minimum distance between the soldering pattern and the locating column may be greater than or equal to 1 mm.

In this embodiment of the present application, the minimum distance between the soldering pattern and the locating column is greater than or equal to 1 mm, so that a space can be reserved between the soldering joint 30 and the locating column, and thus, during a soldering process, interference between the locating column and the pressure head of the soldering device can be avoided.

Optionally, a limiting protrusion 12 may be disposed at a position of the bonding pad body opposite to the diode 40. The bonding pad 10 is soldered to a lead 41 of the diode 40. The limiting protrusion 12 extends along the first direction, the lead 41 may be disposed between the limiting protrusion 12 and the bottom of the box body, and the limiting protrusion 12 may be configured to limit the lead 41 to ensure that the lead 41 is laid out along the first direction.

In this embodiment of the present application, the lead 41 of the diode 40 can be limited by the limiting protrusion 12 to ensure that the lead 41 is laid out along the first direction, thereby improving the reliability of electrical signal transmission of the diode 40.

Specifically, the extension direction of the limiting protrusion 12 may be consistent with the extension direction of the lead 41 of the diode 40.

Optionally, the size of the limiting protrusion 12 extending along the first direction may be 3.48±0.5 mm.

Further, a gap is reserved between an end of the limiting protrusion 12 far away from the bonding pad body and the diode 40 in the first direction, and the gap may be used for routing the leading-out wire 50 of the junction box.

In some other embodiments of the present application, the quantity of the bonding pads 10 may be 2. The two bonding pads 10 may be symmetrically disposed on two sides of the diode 40 along the first direction. The two bonding pads 10 are respectively soldered to the two leads 41 of the diode 40.

In this embodiment of the present application, the two leads 41 of the diode 40 are respectively soldered by using the two bonding pads 10, so that the convenience in arrangement of the diode 40 can be improved, and the signal transmission of the diode 40 can be ensured.

Optionally, the junction box may include an arch-shaped connector. One end of the arch-shaped connector may be fixedly connected to the limiting protrusion 12 of one of the bonding pads 10, and the other end of the arch-shaped connector may be fixedly connected to the limiting protrusion 12 of the other bonding pad 10. The arch-shaped connector and the bottom of the box body may enclose an accommodating space, and the accommodating space may be used for placement of the diode 40.

In this embodiment of the present application, the arch-shaped connector is used to respectively connect the limiting protrusions 12 on the two bonding pads 10, so as to effectively ensure that the two leads 41 of the diode 40 are spread on a same straight line.

Specifically, the arch-shaped connector and the bottom of the box body enclose an accommodating space for placement of the diode 40, so that an opening of the arch-shaped structure faces downward towards the bottom of the box body, so as to facilitate the soldering of the diode 40 and the bonding pad 10.

Specifically, the diode 40 may have an axial structure, and two leads 41 made of a copper base material are provided at two ends. As shown in FIG. 5 to FIG. 9B, the leads 41 of the diode 40 may be soldered to a side of the bonding pad 10 close to the bottom of the box body.

Specifically, in a process of assembling the junction box, the leads 41 of the diode 40 may be soldered to the bonding pad 10 first, and then, the bonding pad 10 is mounted in the box body by means of cooperation of the locating column and the locating hole 11.

The foregoing described apparatus embodiments are merely examples. The units described as separate parts may or may not be physically separate, and the parts displayed as units may or may not be physical units, may be located in one position, or may be distributed on a plurality of network units. Some or all of the modules may be selected according to actual needs to achieve the objectives of the solutions of the embodiments. Those of ordinary skill in the art may understand and implement the embodiments of the present application without creative work.

"One embodiment", "embodiment", or "one or more embodiments" mentioned in this specification means that particular features, structures, or characteristics described with reference to the embodiments may be included in at least one embodiment of the present application. In addition, it should be noted that the phrase example herein of "in an embodiment" does not necessarily refer to a same embodiment. Numerous specific details are set forth in the specification provided herein. However, it can be understood that the embodiments of the present application may be practiced without these specific details. In some examples, known methods, structures, and technologies are not disclosed in detail, so as not to obscure the understanding on the specification.

In the claims, any reference signs placed between parentheses shall not be construed as limiting the claims. The word "include" does not exclude the presence of elements or steps not listed in the claims. The word "a" or "one" before an element does not exclude the presence of a plurality of such elements. The present application may be implemented through hardware including a plurality of different elements and a suitably programmed computer. In the unit claims enumerating a plurality of apparatuses, a plurality of these apparatuses may be specifically embodied by the same item of hardware. The use of the words such as "first", "second", and "third" does not denote any order. These words may be interpreted as names.

Finally, it should be noted that the foregoing embodiments are merely intended for describing the technical solutions of the present application, but not for limiting the present application. Although the present application is described in detail with reference to the foregoing embodiments, those of ordinary skill in the art should understand that modifications may still be made to the technical solutions described in the foregoing embodiments or equivalent replacements may be made to some technical features thereof, provided that such modifications or replacements do not cause the essence of corresponding technical solutions to depart from the spirit and scope of the technical solutions of the embodiments of the present application.

## Claims

1. A photovoltaic module, comprising:
a junction box, comprising a bonding pad; and
a busbar, one end of the busbar being attached to a surface of the bonding pad and soldered to the bonding pad through at least one soldering joint, wherein
the soldering joint penetrates through one end of the busbar, and extends into the bonding pad, the extension depth of the soldering joint in the bonding pad is x, the length of the soldering joint is y, satisfying y≥-5x+4.5, and the unit of both x and y is mm.

2. The photovoltaic module according to claim 1, wherein y≤-5x+5.5 is satisfied.

3. The photovoltaic module according to claim 1, wherein x≥0.2 mm is satisfied.

4. The photovoltaic module according to claim 1, wherein the quantity of the soldering joints is greater than or equal to 3 and less than or equal to 8.

5. The photovoltaic module according to claim 1, wherein y≥1.5 mm is satisfied.

6. The photovoltaic module according to claim 1, wherein a plurality of soldering joints are provided, the plurality of soldering joints are sequentially arranged at intervals along a width direction of the busbar, and a gap exists between two adjacent soldering joints;
a width of the soldering joint is greater than or equal to 0.7 mm and less than or equal to 0.9 mm; and
the gap is greater than or equal to 0.9 mm and less than or equal to 1.1 mm.

7. The photovoltaic module according to claim 1, wherein an end surface of the bonding pad close to the busbar has a planar structure, and a side surface of the busbar attached to the bonding pad also has a planar structure.

8. The photovoltaic module according to claim 1, wherein a material of the busbar is the same as a material of the bonding pad.

9. The photovoltaic module according to claim 8, wherein the material of the busbar and the material of the bonding pad are both copper.

10. The photovoltaic module according to claim 1, wherein the material of the busbar is different from the material of the bonding pad.

11. The photovoltaic module according to claim 1, wherein a width of the busbar is greater than or equal to 5 mm, and a thickness of the busbar is greater than or equal to 0.2 mm.

12. The photovoltaic module according to claim 1, wherein the soldering joint is formed by laser soldering.

13. The photovoltaic module according to claim 1, wherein the junction box is fixed onto a back sheet of the photovoltaic module, and the busbar extends into the junction box through a through hole of the back sheet.

14. A photovoltaic module, comprising:
a junction box, comprising a bonding pad; and
a busbar, one end of the busbar being attached to a surface of the bonding pad and soldered to the bonding pad through at least one soldering joint, wherein
the soldering joint penetrates through one end of the busbar, and extends into the bonding pad, and the extension depth of the soldering joint in the bonding pad is x, satisfying x≥0.2 mm.

15. The photovoltaic module according to claim 14, wherein the quantity of the soldering joints is greater than or equal to 3 and less than or equal to 8.

16. The photovoltaic module according to claim 14, wherein a length of the soldering joint is greater than or equal to 1.5 mm.

17. The photovoltaic module according to claim 14, wherein a plurality of soldering joints are provided, the plurality of soldering joints are sequentially arranged at intervals along a width direction of the busbar, and a gap exists between two adjacent soldering joints;
a width of the soldering joint is greater than or equal to 0.7 mm and less than or equal to 0.9 mm; and
the gap is greater than or equal to 0.9 mm and less than or equal to 1.1 mm.

18. The photovoltaic module according to claim 14, wherein an end surface of the bonding pad close to the busbar has a planar structure, and a side surface of the busbar attached to the bonding pad also has a planar structure.

19. The photovoltaic module according to claim 14, wherein a material of the busbar is the same as a material of the bonding pad.

20. The photovoltaic module according to claim 19, wherein the material of the busbar and the material of the bonding pad are both copper.

21. The photovoltaic module according to claim 14, wherein the material of the busbar is different from the material of the bonding pad.

22. The photovoltaic module according to claim 14, wherein a width of the busbar is greater than or equal to 5 mm, and a thickness of the busbar is greater than or equal to 0.2 mm.

23. The photovoltaic module according to claim 14, wherein the soldering joint is formed by laser soldering.

24. The photovoltaic module according to claim 14, wherein the junction box is fixed onto a back sheet of the photovoltaic module, and the busbar extends into the junction box through a through hole of the back sheet.

25. A photovoltaic module, comprising a junction box and a busbar, the junction box comprising a bonding pad and a diode, wherein the bonding pad and the diode are disposed in parallel along a first direction;
the busbar and the bonding pad are soldered together by laser soldering, a plurality of soldering joints are formed by the laser soldering, and the plurality of soldering joints penetrate through the busbar and extend into the bonding pad;
an edge of the soldering joint closest to the diode along the first direction is a first edge, and an edge of the diode closest to the soldering joint along the first direction is a second edge; and
a safe distance is reserved between the first edge and the second edge, the safe distance is a linear distance between the first edge and the second edge in the first direction, and the safe distance is greater than or equal to 3 mm.

26. The photovoltaic module according to claim 25, wherein the bonding pad and/or the busbar has a sheet structure and has a flat soldering surface.

27. The photovoltaic module according to claim 25, wherein the plurality of soldering joints form a soldering pattern, and a minimum distance between an edge of the soldering pattern and an edge of the bonding pad is greater than or equal to 1.5 mm.

28. The photovoltaic module according to claim 27, wherein the junction box further comprises a box body, the box body comprises a box wall surrounding the bonding pad, and a minimum distance between the soldering pattern and the box wall is greater than or equal to 2.5 mm.

29. The photovoltaic module according to claim 28, wherein an end of the bonding pad far away from the diode is provided with a locating hole, a bottom of the box body is provided with a locating column, and the locating column is inserted through the locating hole.

30. The photovoltaic module according to claim 29, wherein a minimum distance between the soldering pattern and the locating column is greater than or equal to 1 mm.

31. The photovoltaic module according to claim 25, wherein a side of the bonding pad opposite to the diode is provided with a limiting protrusion;
the bonding pad is soldered to a lead of the diode; and
the limiting protrusion extends along the first direction, the lead is disposed between the limiting protrusion and the bottom of the box body, and the limiting protrusion is configured to limit the lead to ensure that the lead is laid out along the first direction.

32. The photovoltaic module according to claim 31, wherein the quantity of the bonding pads is two;
the two bonding pads are symmetrically disposed on two sides of the diode along the first direction; and
the two bonding pads are respectively soldered to the two leads of the diode.

33. The photovoltaic module according to claim 25, wherein the quantity of the soldering joints is greater than or equal to four.

34. The photovoltaic module according to claim 25, wherein a length of the soldering joints is greater than or equal to 3 mm, and a distance between two adjacent soldering joints is greater than or equal to 0.7 mm.

35. The photovoltaic module according to claim 25, wherein a width of the busbar is greater than or equal to 5 mm, and a thickness of the busbar is greater than or equal to 0.2 mm.

36. The photovoltaic module according to claim 25, wherein a depth of the soldering joint extending into the bonding pad is greater than or equal to 0.2 mm.
